(19) Europäisches Patentamt

European Patent Office

Office européen des brevets

(11) EP 1 432 194 A1

(12) EUROPEAN PATENT APPLICATION

(43) Date of publication:
23.06.2004 Bulletin 2004/26

(51) Int Cl.⁷: H04L 27/36, H03F 1/32

(21) Application number: 02028527.6

(22) Date of filing: 19.12.2002

(84) Designated Contracting States:
AT BE BG CH CY CZ DE DK EE ES FI FR GB GR
IE IT LI LU MC NL PT SE SI SK TR
Designated Extension States:
AL LT LV MK RO

(71) Applicant: Nokia Corporation
02150 Espoo (FI)

(72) Inventors:
• Schulte, Olaf
  40878 Ratingen (DE)
• Gaschler, Dirk
  42929 Wermelskirchen (DE)

(74) Representative: Eisenführ, Speiser & Partner
Patentanwälte Rechtsanwälte
Arnulfstrasse 25
80335 München (DE)

(54) **Adaptive predistortion scheme with delay tracking**

(57)     The present invention relates to a method and apparatus for synchronizing an original data sequence (IS) having a symbol rate and a corresponding processed output signal (OS), wherein a delay between a sampled signal of a characteristic parameter of the output signal, sampled at a sampling rate higher than said symbol rate, and a reference signal (MS) adapted to the sampled signal (SS) is estimated and used for controlling a delay between the original data sequence (IS) and said sampled signal (SS). Thereby, a tracking of changing delays can be achieved, which improves the performance of error compensation and/or pre-distortion.

Fig. 1

EP 1 432 194 A1

## Description

FIELD OF THE INVENTION

The present invention relates to a method and apparatus for synchronizing an original data sequence having a symbol rate and a corresponding processed output signal which may be obtained e.g. by modulating the original data sequence or by other signal processing containing analogue processing steps providing a time shift depending on temperature variations, aging effects and production tolerances during processing.

BACKGROUND OF THE INVENTION

In order for adaptive signal compensation or correction systems e.g. known from WO 98/24209 to work effectively, accurate alignment of the original and a distorted signal has to be provided.

A system using non-constant envelope modulations transmitted through non-linear stages, e.g. power amplifiers, modulators or demodulators, suffers from severe performance degradations caused by distortions in the processed signal constellation and intersymbol interference, which limit bit error performance. Additional problems are caused by intermodulation products, which cause spectral regrowth and adjacent channel interference. The transmission of high data capacities is based on digital modulation schemes, such as bandwidth efficient QAM (Quadrature Amplitude Modulation) or PSK (Phase Shift Keying). Such systems do suffer from deviations in gain, balance, quadrature and bias. Especially high order QAM systems are sensitive to quite small deviations of the original complex constellation diagram. Those errors are generated in the analog base band and RF (radio frequency) hardware. Without compensation of the error effects the receiver will not be able to determine the original transmitted digital data.

A correction algorithm of gain, balance, quadrature and bias errors uses a comparison of the original signal with respect to a distorted signal after processing. Both signals do have a time shift caused by group delay of digital and analog components. However, perfect error detection and error compensation or pre-distortion can only be guaranteed with ideal synchronization of the original signal and distorted signal.

In former products a single initial manual tuning operation has achieved synchronization. Consequently, variations of the delay in the analog parts due to temperature variations, aging effects or production tolerances cannot be tracked during subsequent operation of the system. Thus, the performance of error tracking and error correction, or pre-distortion is sub-optimal.

SUMMARY OF THE INVENTION

It is therefore an object of the present invention to provide an automatic synchronization scheme, by means of which delay variations between the original signal and a processed output signal can be reduced and automatically matched during operation.

This object is achieved by an apparatus for synchronizing an original data sequence having a symbol rate and a corresponding processed output signal, said apparatus comprising:

- sampling means for sampling said output signal at a sampling rate higher than said symbol rate to obtain a sampled output signal;
- matching means for generating from said original data sequence a reference signal adapted to said sampled output signal;
- estimation means for estimating a delay between said sampled output signal and said reference signal; and
- delay adjusting means for controlling a delay between said original data sequence and said sampled output signal before both components will be compared based on said estimated delay.

Additionally, the above object is achieved by a method of synchronizing an original data sequence having a symbol rate and a corresponding processed output signal, said method comprising the steps of:

- obtaining a sampled output signal by sampling of said output signal at a sampling rate higher than said symbol rate;
- generating from said original data sequence a reference signal adapted to said sampled output signal;
- estimating a delay between said sampled output signal (SS) and said reference signal; and
- controlling a delay between said original data sequence and said sampled output signal based on the result of said estimation step.

Accordingly, an automatic delay synchronization scheme is provided for adjusting the time correlation between an original data symbol sequence and a corresponding processed output e.g. when the processing means use an internal error compensation or signal pre-distortion. Especially, for high order QAM signals and/or when highest transmission frequencies are used, incorrect delay synchronization causes an insufficent bit error rate in the receiver. A tracking of the changing delays can thus improve the performance of the error compensator and/or the pre-distorter.

Such a signal delay synchronization scheme for automatically adjusting the correlation between the original digital data symbol sequence and a corresponding analogue processed output signal is an important requirement for exact operation of error compensation or pre-distortion means for instance in transmitters, such where enhanced accuracy is specifically needed.

Furthermore, a correlation of the sampled output signal and the reference signal may be used for estimating a group delay between the sampled output signal and the original digital data symbol sequence.

The input data sequence may comprise complex data symbols.

The output signal may be sampled with multiple times the symbol rate to obtain an a multiple-times over-sampled output signal.

The estimation process may be adapted to select a first delay to be used for rough adjustment and a second delay to be used for fine adjustment. The first delay may be sampled or quantized on the basis of the symbol rate and the second delay may be sampled or quantized on the basis of N times the symbol rate, wherein both first and second delays may be arranged to provide in combination a synchronizing adjustment having a resolution that is higher than said symbol rate..

The first delay may be selected to be greater or equal than said estimated delay between the sampled output signal and the reference signal, while the second delay may be selected in such a way that the sum of estimated delay and of the second delay is as close as possible to the selected first delay.

The delay adjustment may comprise a rough adjustment controlled in accordance with the selected first delay, and a fine adjustment controlled in accordance with the selected second delay. In particular, the rough and fine adjustments may be controlled together by a single control word, the most significant bits of the single control word being supplied to or used for the rough adjustment, while the least significant bits of the single control word being supplied to or used for the fine adjustment.

According to the invention, the rough adjustment allows a resolution depending on the original data sequence, while the fine adjustment allows a resolution depending on the sampling rate of the sampled signal. The adjustable resolution of the delay elements in the original digital data path depends on the symbol duration and thus allows a rough synchronization only. The adjustable resolution in the other path depends on the sampling rate at the processing output. Due to an over-sampling of the symbol rate a fine-tuning and an accurate delay tracking is possible.

Further advantageous developments of the present invention are defined in the dependent claims.

BRIEF DESCRIPTION OF THE DRAWINGS

In the following, the present invention will be described in greater detail based on a preferred embodiment with reference to the accompanying drawings, in which:

Fig. 1 shows a schematic block diagram of a synchronization circuit arrangement according to a preferred embodiment of the present invention; and

Fig. 2 shows a schematic diagram indicating a delay control scheme according to the preferred embodiment.

DESCRIPTION OF THE PREFERRED EMBODIMENT

The preferred embodiment will now be described on the basis of a delay synchronization scheme for a transmitter, which may be used for transmitting a QAM signal in a communication system.

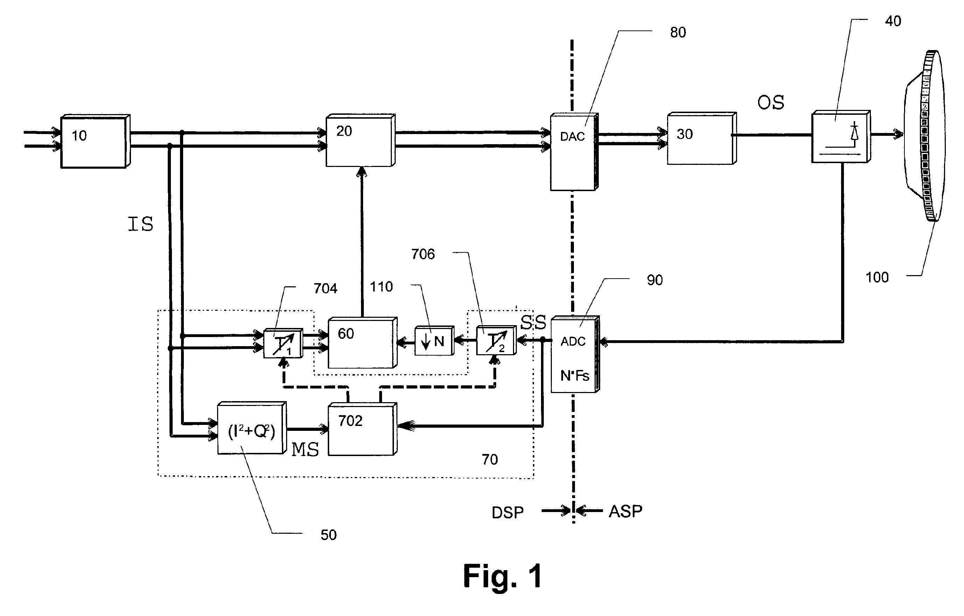

Fig. 1 shows a preferred schematic block diagram of the automatic delay synchronization scheme applied in a modulator of a radio transmitter. The controlling scheme for the delay synchronization is adapted to achieve an automatic time correlation between an original base band signal IS obtained from a connected network entity 10 and a sampled output signal SS derived by a sampling circuit 90 which is arranged to sample an output signal OS obtained at the output of a signal processing circuit 30 which may consist of at least one processing stage, such as a modulation circuit and/or an amplifying circuit and the like with analog signal processing effecting unstable group delay.

A delay estimator 702 which is provided in a delay synchronizer 70 uses a reference signal MS generated by a matching circuit 50, connected at the input of an error compensation and/or pre-distortion circuit 20, as a internal reference signal MS. The matching circuit 50 may be an arithmetic or logic circuit arranged to generate the reference signal MS adapted to the kind of the sampled output signal SS generated by the sampling circuit 90. As an example, the sampled output signal SS may be a sampled envelope of the output signal OS. Consequently, the matching circuit 50 is arranged to generate an envelope signal from the input base band signal IS. Based on a comparison between the reference signal MS and the sampled output signal SS a signal correlation is calculated at the delay estimator 702. The delay estimator controls at least one adjustable delay element arranged in at least one signal-comparing path to a comparison circuit 60 based on the result of the correlation calculation. Thereby, the input base band signal IS and the sampled output signal SS can be synchronized and supplied to the comparison circuit 60 adapted to determine errors or distortions between the compared signals and to generate a control output supplied to the error compensation and/or pre-distortion circuit 20.

Hence, the synchronization of the input base band signal IS with its related sampled output signal SS can be done automatically on the fly. Variations of the delay e.g. in an analog signal processing part of the circuit arrangement, due to temperature variation, aging effects or production tolerances can be tracked. Time and cost expensive manual calibration during production is thus no longer needed.

The sampled output signal SS is obtained by an analog/digital converter (ADC) 90 operating with a sampling rate of N times the transmitted symbol rate $F_S$ of input base band signal IS.

To achieve the synchronization, the correlation between the sampled signal SS and the internally generated reference signal MS is calculated in the group delay estimator 702 and used for estimation of the group delay. The reference signal MS is generated at the matching circuit 50 as a signal that matches as best as possible to the sampled signal SS. Based on the estimated group delay, two delay adjusting circuits 704, 706 are controlled to generate respective signal delays $T_1$ and $T_2$, respectively. The original base band signal IS is supplied via the first delay adjusting circuit 704 to the comparing circuit 60, and the sampled output signal SS is supplied via the second delay adjusting circuit 706 and an under-sampling circuit 110 to the comparator 60. The under-sampling circuit 110 is adapted to reduce the sampling rate of the over-sampled output signal SS e. g. by averaging or interpolation, so that the sampling rates of both compared signals are matched. The result of the comparison is then used in known manner to generate a control signal for controlling the error compensation and/or pre-distortion circuit 20. The error compensation may be adapted to compensate for at least one of a bias error, a balance error, a quadrature error, a gain error and other errors to be compensated, which may be generated in the processing circuit 30.

The sampled output signal SS can be the envelope, squared magnitude of the envelope or any other signal of the output signal OS, e.g. an RF signal transmitted via an array antenna arrangement 100. In the preferred embodiment, the sampled signal SS corresponds to the squared magnitude of the envelope of the output signal OS. Due to this, the reference signal MS is also generated in the matching circuit 50 to correspond to the squared magnitude of the envelope of the digital data symbols or input base band signal IS.

A circuit 40 may comprise a directional coupler with an RF detection diode arrangement. The QAM modulation may be obtained by supplying the complex I and Q components of the error-corrected and/or pre-distorted and processed base band signal via a digital-to-analog converter DAC 80 and a processing circuit 30. The processing circuit 30 provides a 256 QAM modulation, by which the original data signal can be transmitted as QAM symbols. The output signal OS corresponds with the QAM modulated RF signal that causes the sampled signal SS. As indicated in Fig. 1, the DAC 80 in the forward path and the ADC 90 in the feedback path both separate the digital signal processing part DSP from the analog signal processing part ASP.

The squared magnitude of the original complex base band signal IS and the sampled output signal SS are correlated to estimate the real delay $T_{real}$ between both signals resulting from all digital and analog processing delays. The estimated delay $T_{est}$ can be separated into a delay $T_1$ and $T_2$. While $T_1$ is operating on symbol rate $F_S$, delay $T_2$ is operating on N times the symbol rate $F_S$. The remaining error between the real and the estimated time delay is depending on the over-sampling rate N. The smallest adjustable delay is $1/(N * F_S)$. The remaining synchronisation mismatch meets the following inequation:

$$|T_{real} - T_{est}| \leq \frac{1}{2N^*F_S}$$

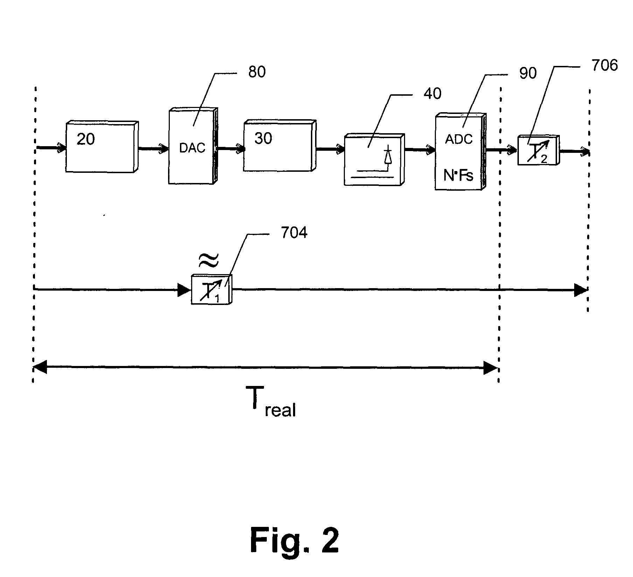

Fig. 2 shows a schematic diagram indicating how the two delay adjusting circuits 704, 706, which may be implemented as controllable delay lines, and the other digital and analog components can be interpreted. The delay $T_1$ leads to a synchronisation near $T_{real}$ and is working on symbol rate $F_S$. For fine-tuning the output signal OS is sampled with N times the symbol rate $F_S$. The delay $T_2$ is programmable in the range of 0 to (N-1). A delay greater or equal N is split into the delay $T_1$ based on the symbol rate $F_S$ and the delay $T_2$ based on N times the symbol rate Fs.

The delay $T_1$ is chosen by the group delay estimator 702 so that it is greater or equal the delay $T_{real}$ of the digital and analog processing chain indicated by the upper processing chain in Fig. 2. Then the delay $T_2$ is selected by the group delay estimator 702 in such a way that the delay of the total upper chain in Fig. 2 is as close as possible to $T_1$. The remaining synchronisation mismatch will then be smaller than $1/(2N * F_S)$.

The delays $T_1$ and $T_2$ of the first and second delay adjusting circuits 704, 706 may be controlled by only one control parameter supplied from the group delay estimator 702. The control parameter is pointing out the distance of the correlation peaks in case of the real existing time shift $T_{real}$ with respect to an assumed time shift equal to zero. In case the number M is a number to the power of 2, the $\log_2(M)$ least significant bits (LSB's) of the control parameter can be used for adjusting $T_2$ and the remaining most significant bits (MSB's) of the control parameter for adjusting $T_1$. The value of the MSB's of the control parameter is thus proportional to the delay $T_1$, i.e. a higher value means higher delay and vice versa. However, the value of the LSB's is anti-proportional to the delay $T_2$, i.e. a higher value means lower delay and vice versa.

It is noted that the present invention is not restricted to the preferred embodiment described above but can be used in any synchronization function for any signal processing circuit. Moreover, any kind of delay adjustment can be implemented, i.e. only in the branch of the sampled signal, only in the branch of the input signal, or in both branches. Any kind of estimation can be used for estimating the delay between the input and output signals. The preferred embodiment may thus vary within the scope of the attached claims.

**Claims**

1. An apparatus for synchronizing an original data sequence (IS) having a symbol rate ($F_S$) and a corresponding processed output signal (OS), said apparatus comprising:

   a) sampling means (90) for sampling said output signal (OS) at a sampling rate higher than said symbol rate to obtain a sampled output signal (SS);

   b) matching means (50) for generating from said original data sequence (IS) a reference signal (MS) adapted to said sampled output signal (SS);

   c) estimation means (702) for estimating a delay between said sampled output signal (SS) and said reference signal (MS); and

   d) delay adjusting means (704, 706) for controlling a delay ($T_{real}$) between said original data sequence (IS) and said sampled output signal (SS) based on said estimated delay.

2. An apparatus according to claim 1, further comprising analog processing means (30) for generating said output signal (OS).

3. An apparatus according to claim 2, wherein said analog processing means (30) provides a QAM modulation.

4. An apparatus according to any one of the preceding claims, wherein said sampling means (40) is adapted to sample the envelope of said output signal (OS).

5. An apparatus according to any one of claims 1 to 3, wherein said sampled output signal (SS) corresponds to a squared envelope of said output signal (OS).

6. An apparatus according to any one of the preceding claims, wherein said estimation means (702) is adapted to use a correlation of the sampled output signal (SS) and said reference signal (MS) for estimating a group delay between said sampled signal (SS) and said reference signal (MS).

7. An apparatus according to any one of the preceding claims, wherein said original data sequence comprises complex data symbols.

8. An apparatus according to claim 1, wherein said sampling means (90) is adapted to sample said output signal with multiple times of said symbol rate ($F_S$) to obtain a sampled output signal that is multiple-times over-sampled.

9. An apparatus according to claim 1, wherein said estimation means (702) is adapted to control said delay adjusting means (704, 706) to provide a first delay (T1) that is quantized on the basis of said symbol rate and a second delay (T2) that is quantized on the basis of multiple times of said symbol rate, wherein said first and second delays are arranged to provide in combination a synchronizing adjustment having a resolution that is higher than said symbol rate ($F_S$).

10. An apparatus according to claim 9, wherein said first delay (T1) is selected to be greater or equal than said estimated delay.

11. An apparatus according to claim 9 or 10, wherein said delay adjusting means (704, 706) is controlled together by a single control word, the most significant bits of said single control word being used by said delay adjusting means (704, 706) to control said first delay (T1) and the least significant bits of said single control word being used by said delay adjusting means (704, 706) to control said second delay (T2).

12. An apparatus according to claim 8, further comprising under-sampling means (110) adapted to reduce or annul the sampling rate of over-sampled output signal (SS) to said symbol rate ($F_S$).

13. A transmitter circuit comprising a synchronization apparatus according to any one of claims 1 to 12.

14. A method of synchronizing an original data sequence (IS) having a symbol rate ($F_S$) and a corresponding processed output signal (OS), said method comprising the steps of:

   a) obtaining a sampled signal by sampling a characteristic parameter of said output signal at a sampling rate higher than said symbol rate;

   b) generating from said original data sequence a reference signal (MS) adapted to said sampled output signal (SS);

   c) estimating a delay between said sampled signal (SS) and said reference signal (MS); and

   d) controlling a delay between said original data sequence (IS) and said sampled output signal (SS) based on the result of said estimation step.

15. A method according to claim 14, further comprising the step of generating said output signal (OS) by applying an analog processing scheme.

16. A method according to claim 15, wherein said analog processing scheme is a QAM modulation.

17. A method according to any one of claims 14 to 16, wherein said sampling step is adapted to sample the envelope of said output signal (OS).

18. A method according to any one of claims 14 to 16, wherein said sampled output signal corresponds to a squared envelope of said output signal (OS).

19. A method according to any one of claims 14 to 18, wherein a correlation of said sampled output signal (SS) and said reference signal (MS) is used in said estimation step to estimate a group delay between said sampled output signal (SS) and said reference signal (MS).

20. A method according to any one of claims 14 to 19, wherein said original data sequence comprises complex data symbols.

21. A method according to any one of claims 14 to 20, wherein said sampling step is adapted to sample said output signal (OS) with multiple times of said symbol rate ($F_S$) to obtain a multiple-times over-sampled output signal.

22. A method according to claim 21, wherein said delay adjusting step provides a first delay (T1) that is quantized on the basis of said symbol rate and a second delay (T2) that is quantized on the basis of N times said symbol rate, wherein said first and second delays are arranged to provide in combination a synchronizing adjustment having a resolution that is higher than said symbol rate ($F_S$).

23. A method according to claim 22, wherein said second delay (T2) is selected to be greater or equal than said estimated delay.

24. A method according to claim 22 or 23, wherein said delay adjusting step is controlled by a single control word, the most significant bits of said single control word being used to control said first delay (T1) and the least significant bits of said single control word being used to control said second delay (T2).

25. A method according to claim 21, wherein said over-sampled output signal (SS) is under-sampled to reduce or annul the sampling rate to said symbol rate (Fs).

Fig. 1

**Fig. 2**

**European Patent Office**

# EUROPEAN SEARCH REPORT

Application Number

EP 02 02 8527

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 903 611 A (SCHNABL GOTTFRIED ET AL) 11 May 1999 (1999-05-11) <br> * column 1, line 1-11 * <br> * column 2, line 62-67 * <br> * column 4, line 4 - line 58 * <br> * column 5, line 12-18 * <br> * column 5, line 48-56 * <br> * column 9, line 34 - line 65 * <br> * figures 1,4,9 * <br> --- | 1-25 | H04L27/36 <br> H03F1/32 |
| A | US 2001/005402 A1 (KUBO TOKURO ET AL) 28 June 2001 (2001-06-28) <br> * abstract * <br> * paragraph [0016] * <br> * paragraph [0052] * <br> * paragraph [0054] * <br> * paragraph [0065] - paragraph [0066] * <br> * paragraph [0070] * <br> * figure 1 * <br> --- | 1-25 | |
| A | GB 2 376 583 A (WIRELESS SYSTEMS INTERNAT LTD) 18 December 2002 (2002-12-18) <br> * abstract * <br> * page 6, paragraph 2 - page 7, paragraph 1 * <br> ----- | 1-25 | TECHNICAL FIELDS SEARCHED (Int.Cl.7) <br><br> H04L <br> H03F |

The present search report has been drawn up for all claims

| Place of search | Date of completion of the search | Examiner |
|---|---|---|
| MUNICH | 25 February 2003 | Baltersee, J |

EPO FORM 1503 03.82 (P04C01)

## ANNEX TO THE EUROPEAN SEARCH REPORT
## ON EUROPEAN PATENT APPLICATION NO.

EP 02 02 8527

This annex lists the patent family members relating to the patent documents cited in the above-mentioned European search report.
The members are as contained in the European Patent Office EDP file on
The European Patent Office is in no way liable for these particulars which are merely given for the purpose of information.

25-02-2003

| Patent document cited in search report | | Publication date | Patent family member(s) | | Publication date |
|---|---|---|---|---|---|
| US 5903611 | A | 11-05-1999 | FR 2746564 A1 | | 26-09-1997 |
| | | | AT 213108 T | | 15-02-2002 |
| | | | AU 711697 B2 | | 21-10-1999 |
| | | | AU 1637297 A | | 25-09-1997 |
| | | | CA 2200387 A1 | | 22-09-1997 |
| | | | DE 69710235 D1 | | 21-03-2002 |
| | | | DE 69710235 T2 | | 19-09-2002 |
| | | | EP 0797294 A1 | | 24-09-1997 |
| | | | JP 10032435 A | | 03-02-1998 |
| US 2001005402 | A1 | 28-06-2001 | JP 2001189685 A | | 10-07-2001 |
| GB 2376583 | A | 18-12-2002 | WO 02103890 A2 | | 27-12-2002 |